# EUROPÄISCHE PATENTSCHRIFT

(11) **EP 2 273 129 B1**
(45) Veröffentlichungstag und Bekanntmachung des Hinweises auf die Patenterteilung: **26.08.2015**
(21) Anmeldenummer: 10006762.8
(22) Anmeldetag: 30.06.2010
(51) Int. Cl.: F04D 19/04, H01R 13/52, F04D 25/06, F04D 29/08

(54) **An eine Vakuumpumpe angeschlossene elektrische Verbindungseinheit**
Electrical connection unit which is attached to a vacuum pump
Unité de connection électrique raccordée à une pompe à vide

(30) Priorität: 06.07.2009 DE 102009031983
(43) Veröffentlichungstag der Anmeldung: 12.01.2011
(73) Patentinhaber: LTi Motion GmbH, 35633 Lahnau (DE)
(72) Erfinder: Wiesing, Josef, Dr., 35578 Wetzlar (DE); Wagner, Martin, 35584 Wetzlar (DE)
(74) Vertreter: Schubert, Siegmar

(56) Entgegenhaltungen:
- EP-A2- 0 906 006
- EP-A2- 1 732 178
- EP-A2- 1 843 043
- WO-A1-2008/015105
- DE-U1-202007 012 070
- JP-A- 2006 250 033

## Beschreibung

Die Erfindung betrifft eine an eine Vakuumpumpe angeschlossene elektrische Verbindungseinheit.

Bei Gastransfer-Vakuumpumpen ist üblicherweise jeweils ein Antriebsmotor über eine Antriebswelle mit Unterdruck erzeugenden Mechaniken, insbesondere Pumpenrotorscheiben, Schieber, Drehkolben gekuppelt, die in einem mehrteiligen Gehäuse angeordnet sind, dessen Innenraum im Betrieb der Vakuumpumpe unter Unterdruck steht. Der Innenraum schließt dabei oft die Motorwicklung und gegebenenfalls weitere elektrische Bauteile ein, die mit Strom/Spannung bzw. elektrischen Signalen zu beaufschlagen sind, die außerhalb der Vakuumpumpe, also unter normalen atmosphärischen Bedingungen erzeugt werden und dem Innenraum der Vakuumpumpe zuzuführen sind. Insbesondere können bei einer Bauweise der Vakuumpumpe als Turbomolekularpumpe mit Magnetlagem Signale von internen Sensoren extern außerhalb des Innenraums ausgewertet werden, um entsprechend einer radialen und axialen Verschiebung des Rotors des Antriebsmotors bzw. der Antriebswelle Signale zu erzeugen, mit denen Aktoren bzw. Elektromagnetanordnungen des Rotors betätigt werden. Die Zuführung von Strom/Spannung bzw. elektrischen Signalen, die außerhalb der Vakuumpumpe erzeugt werden, in deren Inneres hat unter hermetischer Trennung des Innenraumes von der die Vakuumpumpe umgebende Atmosphäre zu erfolgen.

Hierzu ist an der Vakuumpumpe eine hermetisch dichte Durchführung der elektrischen Signale vorzusehen, die herkömmlich typisch in Glas vergossene Stifte umfasst, an denen Anschlüsse zu kontaktieren sind, die sich nach Montage in dem Innenraum der Vakuumpumpe befinden. Aussen auf der Atmosphärenseite der Durchführung können die Stifte über einen Stecker mit einem Antriebsgerät verbunden werden. Eine solche Durchführung ist fertigungstechnisch aufwendig herzustellen, in der Anwendung wenig flexibel und in Folge teuer.

Um an einer Vakuumpumpe eine vakuumdichte Durchführung zu schaffen, die eine flexiblere elektrische Signalführung gestatten soll und gegen Montagefehler weniger anfällig sein soll, wurde bereits als Trennelement zwischen einem unter Unterdruck stehenden Innenraum der Vakuumpumpe und deren Antriebsgerät eine gedruckte Schaltungsplatine bekannt, die Mittel zur Durchführung elektrischer Ströme und Spannungen von dem Antriebsgerät auf Atmosphärendruck in den Innenraum der Vakuumpumpe aufweist (DE-A-10 2006 016 405, EP-A-1 843 043). Als Mittel zur Durchführung elektrischer Ströme und Spannungen können in Durchbohrungen der gedruckten Schaltungsplatine gesteckte Stifte mit dieser verlötet sein oder es kann auf der Schaltungsplatine ein dichter Stecker vorgesehen sein, dessen Kontaktstifte einerseits dem Innenraum der Vakuumpumpe zugewandt sind und andererseits in die gedruckte Schaltungsplatine eingelötet sind. Zwischen dem auf das Gehäuse der Vakuumpumpe aufgeschraubten Trennelement und dem Gehäuse kann ein Elastomerring angeordnet sein, um eine einfache sichere Abdichtung zu erzielen. Diese wird durch eine glättende Beschichtung der gedruckten Schaltungsplatine z.B. mit Gold oder einer Goldlegierung verbessert. In der Ausführungsform des Trennelements als gedruckte Schaltungsplatine mit durch diese gesteckte Stifte können auf der dem Innenraum der Turbopumpe zugewandten Seite Stecker auf die Stifte gesteckt sein, die über Leitungen zu elektrischen Komponenten in dem Innenraum der Vakuumpumpe führen, beispielsweise einem Motor. Die Stifte können auch auf der dem Antriebsgerät zugewandten Seite über einen auf diese aufgesteckten Stecker direkt mit einer Antriebselektronik in dem Antriebsgerät verbunden sein. Weitere elektronische Bauteile können auf der Schaltungsplatine angeordnet sein. Insoweit sind Dichtfunktion und Elektronikfunktion auf der Leiterplatte vereint. Die Elektronik, die zu der Vakuumpumpe gehört, kann nicht ohne Lösen des Antriebsgeräts von dem Gehäuse der Vakuumpumpe und ohne Manipulation an der als Trennelement vorgesehenen bedruckten Schaltungsplatine modifiziert werden. Die Abdichtung der an das Gehäuse der Vakuumpumpe geschraubten bedruckten Schaltungsplatine ist nicht stets optimal. Eine gattungsgemäße Verbindungseinheit, in der die Dichtfunktion und die Elektronikfunktion getrennt sind, offenbart JP 2006 250033 A.

Substrate als Träger für Schaltungsanordnungen, die druckdichte Durchkontaktierungen aufweisen, sind allgemein bekannt (DE 197 42 072 B4). Als Substrat kann insbesondere eine keramische Dünnschicht verwendet werden, in der die Durchkontaktierung mit einer gesinterten Leitpaste erfolgt (US 5 274 916, EP 0 456 243 A2).

Der vorliegenden Erfindung liegt die Aufgabe zugrunde, einen einfach zu handhabenden Anschluss einer Vakuumpumpe an eine externe Antriebs- und Steuerelektronik unter Erhaltung eines vakuumdichten Innenraums der Vakuumpumpe zu schaffen, wobei die Vakuumpumpe in jeweils einer von verschiedenen anschließbaren Größen und Bauvarianten vorgesehen sein kann und der Anschluss an die externe Antriebs- und Steuerelektronik standardisiert sein kann. Die hierzu verwendeten Anschlussmittel sollen unkompliziert sein und eine sichere Funktion der Vakuumpumpe gewährleisten.

Diese Aufgabe wird durch eine an die Vakuumpumpe angeschlossene elektrische Verbindungseinheit mit den in Anspruch 1 angegebenen Merkmalen gelöst.

Die erfindungsgemäße elektrische Verbindungseinheit weist als vakuumdichtes Trennelement zwischen einer Atmosphärenseite einer Vakuumpumpe, d.h. deren Umgebung, und einer Vakuumseite, d.h. dem Inneren der Vakuumpumpe, eine einlagige und insofern wenig aufwendige durchkontaktierte Keramikplatte auf, die zwischen einem atmosphärenseitigen Gehäuseteil der Verbindungseinheit und einem vakuumseitigen Gehäuseteil der Verbindungseinheit auf der Vakuumseite vakuumsdicht eingeklemmt ist. Die beiden Gehäuseteile dienen also zur Klemmverbindung der Keramikplatte.

Die glatte Oberfläche der zwischen dem atmosphärenseitigen Gehäuseteil und dem vakuumseitigen Gehäuseteil eingeklemmten Keramikplatte ermöglicht eine unkomplizierte vakuumdichte Abdichtung der Keramikplatte auf der Vakuumseite. Diese Abdichtung wird gewährleistet, indem die Keramikplatte zwischen einem elastischen Dichtungsring auf deren Vakuumseite und einem elastischen O-Ring auf der Atmosphärenseite der Keramikplatte durch das vakuumseitige Gehäuseteil und das atmosphärenseitige Gehäuseteil eingeklemmt ist. Der elastische Dichtungsring auf der Vakuumseite, ein O-Ring, dient außer zur Abdichtung einer elastisch nachgiebigen Lagerung der Keramikplatte, die durch den elastischen O-Ring, der zwischen der Atmosphärenseite der Keramikplatte und dem atmosphärenseitigen Gehäuseteil angeordnet ist und nicht abdichtend zu wirken braucht, vervollständigt ist. Mit der damit erreichten sogenannten schwimmenden Lagerung der Keramikplatte werden mechanische Spannungen in der Keramikplatte und somit die Möglichkeit von Beschädigungen bei hermetischer Abdichtung der Keramikplatte auf der Vakuumseite vermieden.

In dem atmosphärenseitigen Gehäuseteil ist eine Leiterplatte angeordnet, die mit den Durchkontaktierungen der Keramikplatte signalführend verbunden ist und auf der der mindestens eine Steckverbinder angeordnet ist, der in montiertem Zustand der Verbindungseinheit auf der Atmosphärenseite außen angeschlossen werden kann.

Der mindestens eine Steckverbinder, der in dem atmosphärenseitigen Gehäuseteil angeordnet ist, kann direkt über Leitungsdrähte mit Leitern bzw. den Durchkontaktierungen der Keramikplatte verbunden sein.

Die mit dem mindestens einen Steckverbinder und gegebenenfalls Elektrobauteilen bestückte Leiterplatte kann als Einheit herstellungsgünstig vorgefertigt werden.

Durch den mindestens einen Steckverbinder, der in dem atmosphärenseitigen Gehäuseteil der Verbindungseinheit angeordnet ist und an den außen an dem atmosphärenseitigen Gehäuseteil ein Steckverbinderteil angeschlossen werden kann, wird eine elektrische und mechanische Schnittstelle der Verbindungseinheit gebildet.

Die durch den mindestens einen Steckverbinder in dem atmosphärenseitigen Gehäuseteil gebildete Schnittstelle dient als äussere Schnittstelle für die externe Antriebs- und Steuerelektronik der Vakuumpumpe. Die Antriebs- und Steuerelektronik kann als Gerät direkt an den mindestens einen Steckverbinder, der in dem atmosphärenseitigen Gehäuseteil angeordnet ist und an dem atmosphärenseitigen Gehäuseteil auf der Atmosphärenseite anschließbar ist, außen angesetzt werden, wozu das Gerät ein passendes Steckverbinderteil aufweist, oder unter Verwendung eines solchen Steckverbinderteils mittelbar über eine zusätzliche Kabelverbindung.

Die Keramikplatte ist nach Anspruch 2 bevorzugt auch Trägerelement mindestens eines auf deren Vakuumseite angeordneten Steckverbinders, der eine innere mechanische und elektrische Schnittstelle der Verbindungseinheit darstellt, nämlich zu dem Innenraum der Vakuumpumpe und den darin untergeordneten Bauelementen.

Insgesamt kann die erfindungsgemäße Verbindungseinheit als eigenständige vorgefertigte und geprüfte Einheit mit ihrer inneren Schnittstelle an dem Innenraum der Vakuumpumpe montiert werden.

Die Durchkontaktierungen der einlagigen Keramikplatte werden durch eine leitfähige Paste verwirklicht, die insbesondere aus einem Glas-Metall-Verbund besteht, die von Bohrungen in der Keramikplatte aufgenommen wird und gesintert wird. Die damit in der einlagigen Keramikplatte erzielten Durchkontaktierungen sind vakuumdicht.

Gemäß Anspruch 11 sind mit der Leiterplatte - außer dem mindestens einen Steckverbinder - auch signalverarbeitende Elektronikbauteile, die eine Signalvorverarbeitung bewirken, in dem atmosphärenseitigen Gehäuseteil mechanisch und elektrisch verbunden. Der Ausdruck Signalvorverarbeitung bedeutet in dem vorliegenden Zusammenhang, dass eine hieran anschließende Signalverarbeitung in der externen Antriebs- und Steuerelektronik erfolgen kann.

Bevorzugt ist die äußere Schnittstelle und/oder die der innere Schnittstelle der erfindungsgemäßen Verbindungseinheit standardisiert, wozu die voranstehend erwähnten signalverarbeitenden Elektronikbauteile, die nach Anspruch 11 mit der Leiterplatte in dem atmosphärenseitigen Gehäuseteil mechanisch und elektrisch verbunden sind, eine Schaltungsanordnung bilden können, mit der die äussere Schnittstelle an die innere Schnittstelle angepasst wird, die durch den auf der Vakuumseite der Keramikplatte angeordneten Steckverbinder zu den Bauelementen in dem Innenraum der Vakuumpumpe vorliegt. Insbesondere kann mit dieser Schaltungsanordnung bzw. mit den Elektronikbauteilen eine Signalvorverarbeitung in dem atmosphärenseitigen Gehäuseteil der Verbindungseinheit erfolgen, um eine standardisierte äussere Schnittstelle auf der Atmosphärenseite der Verbindungseinheit als Kommunikationsschnittstelle eines Feldbus, eines USB-Bus oder RS 232-Schnittstelle zu bilden. Damit kann die Verbindungseinheit als standardisierte Einheit für verschiedene Pumpengrößen oder Pumpentypen eingesetzt werden.

Durch das einfache Montagekonzept des Zusammenklemmens von Teilen der Verbindungseinheit, welches es gestattet, das atmosphärenseitige Gehäuseteil einfach von der Keramikplatte und dem vakuumseitigen Gehäuseteil zu trennen, kann die äussere Kommunikationsschnittstelle auch nachträglich eingerichtet bzw. verändert werden, z.B. durch Einbau eines zusätzlichen Steckverbinders auf der Leiterplatte, um bei magnetisch gelagerten Vakuumpumpen zusätzliche Anschlüsse für deren Sensorik und/oder Aktorik bereitzustellen. Das einfache Montagekonzept gestattet auch einen einfachen Austausch elektronischer, elektrischer oder mechanischer Bauelemente oder Baugruppen. Ein Eingriff in den Innenraum der Vakuumpumpe ist hierzu also nicht erforderlich.

Die Funktionen der Verbindungseinheit können weiter dadurch erweitert werden, dass nach Anspruch 12 mit der Leiterplatte Speicherbauelemente mechanisch und elektrisch verbunden sind, in denen Fertigungs-, Einstell- und/oder Betriebsdaten gespeichert sind, die über die äußere Schnittstelle nach außen übertragen werden können. Auch diese Speicherbausteine sind im Bedarfsfall durch das einfache Montagekonzept der Verbindungseinheit leicht austauschbar.

Die oben genannte Klemmverbindung der beiden Gehäuseteile, zwischen denen die Keramikplatte, der elastische O-Ring und der elastische Dichtungsring eingeschlossen sind, kann nach Anspruch 3 mit wenigen Schrauben, die um den äußeren Rand der Keramikplatte angeordnet sind und jeweils durch einen Randabschnitt des einen Gehäuseteils in einen Randabschnitt des anderen Gehäuseteils reichen, hergestellt werden und im Bedarfsfall leicht gelöst werden, insbesondere um Elektronikbausteine in den Zwischenraum zwischen der Keramikplatte und dem atmosphärenseitigen Gehäuseteil im Bedarfsfall auszutauschen oder zu ergänzen.

Eine fertigungsgünstige, kompakte und einfach vakuumdicht an eine Vakuumpumpe angeschlossene Verbindungseinheit weist gemäß Anspruch 4 die weiteren Merkmale auf, dass in einem der Keramikplatte zugewandten Abschnitt des atmosphärenseitigen Gehäuseteils eine Nut ausgeformt ist, in der der elastische O-Ring angeordnet ist, dass in einem gegenüberliegenden, der Keramikplatte zugewandten Abschnitt des vakuumseitigen Gehäuseteils eine Nut ausgeformt ist, in der der elastische Dichtungsring angeordnet ist, und dass in einem Abschnitt des vakuumseitigen Gehäuseteils, der der Keramikplatte abgewandt ist, eine Pumpengehäusedichtnut ausgeformt ist, die zur Aufnahme eines elastischen Pumpengehäusedichtungsrings geeignet ist.

Vorteilhaft zur Übertragung des Auspressdruckes zwischen dem elastischen Dichtungsring und dem O-Ring der Verbindungseinheit unter Einschluss der Keramikplatte bei geringer die Keramikplatte verformender Belastung sind nach Anspruch 5 die aus dem atmosphärenseitigen Gehäuseteil ausgeformte Nut sowie die aus dem vakuumseitigen Gehäuseteil ausgeformte Nut miteinander fluchtend, d.h. kongruent angeordnet. Im speziellen Falle einer im Wesentlichen kreisringförmigen Ausbildung der Nuten sind diese somit konzentrisch angeordnet.

Zur montagegünstigen vakuumdichten Anbringung der Verbindungseinheit an der Vakuumpumpe ist nach Anspruch 6 außen aus dem vakuumseitigen Gehäuseteil ein kragenförmiger Abschnitt ausgeformt, der Pumpengehäuseverschraubungsbohrungen aufweist.

Eine zuverlässige elektrische Verbindung in der Verbindungseinheit zwischen der Keramikplatte und Leiterplatte, die leicht lösbar ist, wird gemäß Anspruch 7 dadurch erzielt, dass die Leiterplatte mit der Keramikplatte an deren Atmosphärenseite mittels einer Stiftleiste und einer Buchsenleiste unmittelbar verbunden ist. Die Stiftleiste und die Buchsenleiste können hierzu an Leiterbahnen bzw. Lötflächen der Leiterplatte bzw. Keramikplatte angelötet sein.

Gemäß Anspruch 8 ist die Keramikplatte zumindest auf einer Seite vollständig beschichtet. Die Beschichtung kann nach Anspruch 9 ein Isolierstoff sein kann, um Überschläge auf der Keramikplatte zu vermeiden, oder gemäß Anspruch 10 eine Schutzschicht vor Umgebungseinflüssen.

Eine Schicht zum Glätten eines Teils der Oberfläche der Keramikplatte, nämlich im Bereich des elastischen O-Rings oder des elastischen Dichtungsrings, ist wegen der ohnedies mit glatter Oberfläche herstellbaren Keramikplatte nicht erforderlich.

Ein Ausführungsbeispiel der Erfindung wird im Folgenden anhand einer Zeichnung mit einer Figur erläutert, woraus sich weitere vorteilhafte Einzelheiten der Erfindung ergeben können. Es zeigt:

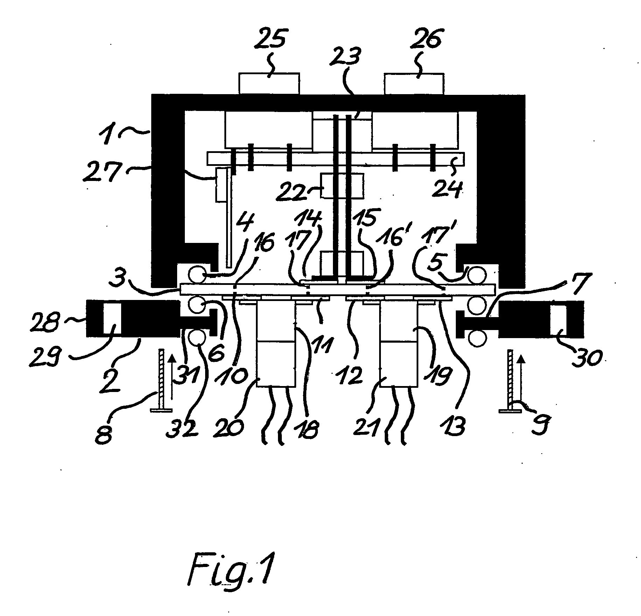

- Figur 1: eine erfindungsgemäße elektrische Verbindungseinheit ohne Vakuumpumpe in einem vereinfacht dargestellten Längsschnitt.

Die an eine nicht gezeigte Vakuumpumpe angeschlossene Verbindungseinheit umfasst im Wesentlichen ein atmosphärenseitiges Gehäuseteil 1 und ein rahmenförmiges, im Querschnitt an das atmosphärenseitige Gehäuseteil 1 im Wesentlichen angepasstes vakuumseitiges Gehäuseteil 2, zwischen denen eine einlagige Keramikplatte 3 eingeklemmt ist. Die Klemmverbindung erstreckt sich über einen elastischen O-Ring 4, der in einer umlaufenden Nut 5 an einem der Keramikplatte 3 zugewandten Abschnitt des atmosphärenseitigen Gehäuseteils 1 liegt, sowie auf der gegenüberliegenden, einem Innenraum der Vakuumpumpe zugewandten Seite der Keramikplatte 3 über einen elastischen Dichtungsring 6 in einer umlaufenden Nut 7 in dem vakuumseitigen Gehäuseteil 2, die der Nut 5 in dem atmosphärenseitigen Gehäuseteil 1 zugewandt ist. Die Klemmverbindung ist durch Befestigungsschrauben, von denen die Befestigungsschrauben 8, 9 in Figur 1 dargestellt sind, realisiert, indem die Befestigungsschrauben, z.B. 8, 9, durch jeweils ein Durchgangsloch in dem vakuumseitigen Gehäuseteil 2 in ein Gewindeloch in dem atmosphärenseitigen Gehäuseteil 1 eingeschraubt sind.

Die Keramikplatte 3 ist, wie in Figur 1 dargestellt, sowohl auf ihrer in der Lage gemäß Figur 1 unteren Seite als auch auf der oberen Seite mit Lötflächen 10 - 13 bzw. 14, 15 versehen, die über Durchkontaktierungen 16, 16', 17, 17' aus Glas-Metall-Verbund in Löchern der Keramikplatte 3 miteinander verbunden sind. Die Lötflächen 16, 16', 17, 17' können Abschnitte von nicht dargestellten Leiterbahnen sein.

Eine mögliche Beschichtung der Keramikplatte 3 aus Isolierstoff oder als Schutzschicht und/oder als Schutzschicht vor Umgebungseinflüssen ist in Figur 1 nicht dargstellt.

Auf die Lötflächen 10 - 13 der dem vakuumseitigen Gehäuseteil 2 bzw. der Vakuumseite zugewandten, in Figur 1 unteren Seite der Keramikplatte 3 sind zwei Steckverbinder 18, 19 oberflächenmontiert, die jeweils einen Kabelgegenstecker 20 bzw. 21 aufnehmen. Die Kabelgegenstecker 20, 21 können über ihre nicht bezeichneten Kabel mit elektrischen Komponenten, wie Statorwicklung eines Antriebsmotors, Magnetiager-Aktoren und -Sensoren in dem Inneren der Vakuumpumpe verbunden sein.

Die Steckverbinder 18, 19 auf der Vakuumseite stehen über die Durchkontaktierungen 16, 16', 17, 17' und die Lötflächen 14, 15 auf der Atmosphärenseite der Keramikplatte 3 in dem haubenartigen atmosphärenseitigen Gehäuseteil 1 mit einem Steckverbinder 22 in Verbindung, der in diesem Ausführungsbeispiel als Stiftleiste ausgebildet ist. Der Steckverbinder 22 bzw. die Stiftleiste ist in SMD-Technik auf den Lötflächen 14, 15 oberflächenmontiert. Die Stiftleiste ist in die Buchsenleiste als Steckverbindergegenpart 23 eingesteckt, der auf einer Leiterplatte 24 angeordnet ist.

Die Leiterplatte 24 kann als Standardplatine ausgeführt sein. Sie ist im montierten Zustand der Verbindungseinheit in einem Abstand parallel zu der Keramikplatte 3 in dem Inneren des atmosphärenseitigen Gehäuseteils 1 angeordnet. Sie trägt auf ihrer in Figur 1 oberen Seite Steckverbinder 25, 26, die mit in Figur 1 nicht dargestellten Lötflächen bzw. Leiterbahnen der Leiterplatte 24 kontaktiert sind.

Auf die Steckverbinder 25, 26 kann von außen auf der Atmosphärenseite jeweils ein Gegenstecker aufgesteckt sein.

Die nicht dargestellten Gegenstecker zu den Steckverbindern 25, 26 auf der Atmosphärenseite können an einem ebenfalls nicht dargestellten elektronischen Antriebs- und Steuergerät befestigt sein, welches mittels der Gegenstecker direkt auf die Steckverbinder 25, 26 gesteckt werden kann. Es ist aber auch möglich, das Antriebs- und Steuergerät über Kabel und die Gegenstecker mit den Steckverbindern 25, 26 elektrisch zu verbinden, ohne eine tragende mechanische Verbindung herzustellen.

Die Leiterplatte 24 kann bei Bedarf weitere Elektronikbausteine, z.B. 27, aufnehmen, die über die Leiterplatte 24 mit dem Steckverbinder 22 und/oder den Steckverbindern 25, 26 verbunden sein können, um eine durch die Steckverbinder 25, 26 gebildete äußere Schnittstelle mit der durch die Steckverbinder 18, 19 an der Keramikplatte 3 verwirklichte Ankopplung bzw. innere Schnittstelle zu den elektrischen/elektronischen Bauelementen in der Vakuumpumpe anzupassen, so dass eine oder beide der genannten Schnittstellen als Standardschnittstellen ausgebildet sein können.

Weitere Elektronikkomponenten 27, die in dem atmosphärenseitigen Gehäuseteil 1 mit der Leiterplatte 24 mechanisch und elektrisch verbunden sind, können als Speicherbauelemente ausgebildet sein, in denen Fertigungs-, Einstell- und/oder Betriebsdaten gespeichert sind, die über die äußere Schnittstelle, gebildet durch die Steckverbinder 25, 26, abgefragt werden können.

Zur Montage der Verbindungseinheit, die wie weiter oben im Einzelnen angegeben aus den beiden Gehäuseteilen 1, 2 unter Einschluss der Keramikplatte 3 zusammengesetzt und mit den Befestigungsschrauben 8, 9 verschraubt ist, an der in Figur 1 nicht gezeigten Vakuumpumpe ist aus dem vakuumseitigen Gehäuseteil 2 ein kragenförmiger Abschnitt 28 in dem vorliegenden Ausführungsbeispiel um das Gehäuseteil 2 umlaufend ausgeformt, der mit Pumpengehäuseverschraubungsbohrungen, z.B. 29, 30, versehen ist. Weiterhin ist in Figur 1 auf der unteren Seite des vakuumseitigen Gehäuseteils 2, d.h. in dessen der Keramikplatte 3 abgewandten Abschnitt, eine Pumpengehäusedichtungsnut 31 ausgeformt, die einen Pumpengehäusedichtungsring 32 aufnimmt.

Wie in Figur 1 dargestellt, fluchten die in dem atmosphärenseitigen Gehäuseteil 1 ausgeformte Nut 5 sowie die Nut 7, die aus dem vakuumseitigen Gehäuseteil 2 ausgeformt ist, womit im zusammengepressten und montierten Zustand der Verbindungseinheit die Biegebeanspruchung der Keramikplatte 3 minimiert wird.

Die Verbindungseinheit wird durch in Figur 1 nicht gezeigte Befestigungsschrauben, die durch die Pumpengehäuseverschraubungsbohrungen 29, 30 hindurch in Gewindebohrungen in dem Pumpengehäuse reichen, mit diesem vakuumdicht verschraubt. Die Vakuumdichtigkeit wird durch den an einer glatten Fläche des Pumpengehäuses anliegenden Pumpengehäusedichtungsring 32 erzielt.

Zusammenfassend erfolgt in der erfindungsgemäßen Verbindungseinheit eine weitgehende funktionale und strukturelle Trennung von Dichtfunktionen und Elektronikfunktionen. Ein einfacher Austausch zumindest eines Teils der Elektronik ist durch Anschluss eines externen Steckers an dem atmosphärenseitigen Gehäuseteil ohne Belastung der Keramikplatte als Trennelement möglich. Es wird eine hohe Flexibilität des Einsatzes mit einer die Funktion der Vakuumpumpe unterstützenden Elektronik ohne Modifikation der Keramikplatte erzielt. Die Keramikplatte kann als solche plan hergestellt werden und bedarf keiner Beschichtung zum Erreichen einer guten vakuumdichten Dichtung. An der vakuumdichten Keramikplatte herrscht eine gleichmäßige mechanische Druckverteilung durch die schwimmende Montage der Keramikplatte, durch die auch Montage-Justage-Toleranzen ausgeglichen werden. Es treten also keine punktförmigen Belastungen der Abdichtung an der Keramikplatte auf, die Undichtigkeiten erzeugen könnten.

### Bezugszahlenliste

- 1: atmosphärenseitiges Gehäuseteil
- 2: vakuumseitiges Gehäuseteil
- 3: Keramikplatte
- 4: elastischer O-Ring
- 5: Nut
- 6: elastischer Dichtungsring
- 7: Nut
- 8: Befestigungsschraube
- 9: Befestigungsschraube
- 10: Lötfläche
- 11: Lötfläche
- 12: Lötfläche
- 13: Lötfläche
- 14: Lötfläche
- 15: Lötfläche
- 16: Durchkontaktierung
- 16': Durchkontaktierung
- 17: Durchkontaktierung
- 17': Durchkontaktierung
- 18: Steckverbinder
- 19: Steckverbinder
- 20: Kabel-Gegenstecker
- 21: Kabel-Gegenstecker
- 22: Stiftleiste (Steckverbinder)
- 23: Buchsenleiste (Steckverbindergegenpart)
- 24: Leiterplatte
- 25: Steckverbinder
- 26: Steckverbinder
- 27: Elektronik-Baustein
- 28: kragenförmiger Abschnitt
- 29: Pumpengehäuseverschraubungsbohrung
- 30: Pumpengehäuseverschraubungsbohrung
- 31: Pumpengehäusedichtungsnut
- 32: Pumpengehäusedichtungsring

## Patentansprüche

1. An eine Vakuumpumpe angeschlossene elektrische Verbindungseinheit mit vakuumdichter Signalführung zwischen einer Atmosphärenseite und einer Vakuumseite der Verbindungseinheit, die mittels einer einlagigen durchkontaktierten Keramikplatte (3) vakuumdicht getrennt sind, wobei die Keramikplatte (3) zwischen einem atmosphärenseitigen Gehäuseteil (1) und einem vakuumseitigen Gehäuseteil (2) jeweils zwischen einem elastischen O-Ring (4) auf der Atmosphärenseite der Keramikplatte (3) und einem elastischen Dichtungsring (6) auf deren Vakuumseite der Keramikplatte (3) mittels des atmosphärenseitigen Gehäuseteils (1) und des vakuumseitigen Gehäuseteils (2) vakuumdicht eingeklemmt ist,
wobei in dem atmosphärenseitigen Gehäuseteil (1) eine Leiterplatte (24) angeordnet ist, die mit Durchkontaktierungen (16, 16', 17, 17') der Keramikplatte (3) signalführend verbunden ist und
wobei auf der Leiterplatte (24) mindestens ein Steckverbinder (25, 26) angeordnet ist, der über die Leiterplatte (24) mit den Durchkontaktierungen (16, 16', 17, 17') der Keramikplatte (3) in signalführender Verbindung steht und außerhalb des atmosphärenseitigen Gehäuseteils (1) anschließbar ist.

2. Verbindungseinheit an einer Vakuumpumpe nach Anspruch 1,
**dadurch gekennzeichnet,**
**dass** an der Vakuumseite der Keramikplatte (3) mindestens ein Steckverbinder (18, 19) angebracht ist, der über die Durchkontaktierungen (16, 16', 17, 17') der Keramikplatte (3) mit dem an dem atmosphärenseitigen Gehäuseteil (1) auf der Atmosphärenseite außen anschließbaren Steckverbinder (25, 26) signalführend verbunden ist.

3. Verbindungseinheit an einer Vakuumpumpe nach Anspruch 1 oder 2,
**dadurch gekennzeichnet,**
**dass** das atmosphärenseitige Gehäuseteil (1) und das vakuumseitige Gehäuseteil (2) unter Einschluss der Keramikplatte (3), des elastischen O-Rings (4) und des elastischen Dichtungsrings (6) miteinander verschraubt sind.

4. Verbindungseinheit an einer Vakuumpumpe nach einem der vorangegangenen Ansprüche,
**dadurch gekennzeichnet,**
**dass** in einem der Keramikplatte (3) zugewandten Abschnitt des atmosphärenseitigen Gehäuseteils (1) eine Nut (5) ausgeformt ist,
in der der elastische O-Ring (4) angeordnet ist,
**dass** in einem gegenüberliegenden, der Keramikplatte (3) zugewandten Abschnitt des vakuumseitigen Gehäuseteils (2) eine Nut (7) ausgeformt ist, in der der elastische Dichtungsring (6) angeordnet ist, und
**dass** in einem Abschnitt des vakuumseitigen Gehäuseteils (2), der der Keramikplatte (3) abgewandt ist, eine Pumpengehäusedichtnut (31) ausgeformt ist, die zur Aufnahme eines elastischen Pumpengehäusedichtungsrings (32) geeignet ist.

5. Verbindungseinheit an einer Vakuumpumpe nach Anspruch 4,
**dadurch gekennzeichnet,**
**dass** die aus dem atmosphärenseitigen Gehäuseteil (1) ausgeformte Nut (5) sowie die Nut (7), die aus dem vakuumseitigen Gehäuseteil (2) ausgeformt sind, miteinander fluchtend angeordnet sind.

6. Verbindungseinheit an einer Vakuumpumpe nach einem der vorangehenden Ansprüche,
**dadurch gekennzeichnet,**
**dass** außen aus dem vakuumseitigen Gehäuseteil (2) ein kragenförmiger Abschnitt (28) ausgeformt ist, der Pumpengehäuseverschraubungsbohrungen (29, 30) aufweist.

7. Verbindungseinheit an einer Vakuumpumpe nach einem der vorangehenden Ansprüche,
**dadurch gekennzeichnet,**
**dass** die Leiterplatte (24) mit der Keramikplatte (3) an deren Atmosphärenseite mittels einer Stiftleiste (22) und einer Buchsenleiste (23) unmittelbar verbunden ist.

8. Verbindungseinheit an einer Vakuumpumpe nach einem der vorangehenden Ansprüche,
**dadurch gekennzeichnet,**
**dass** die Keramikplatte (3) zumindest auf einer Seite vollständig beschichtet ist.

9. Verbindungseinheit an einer Vakuumpumpe nach Anspruch 8,
**gekennzeichnet durch**
einen Isolierstoff als Beschichtung.

10. Verbindungseinheit an einer Vakuumpumpe nach Anspruch 8,
**gekennzeichnet durch**
eine Schutzschicht vor Umgebungseinflüssen als Beschichtung.

11. Verbindungseinheit an einer Vakuumpumpe nach einem der vorangegangenen Ansprüche,
**dadurch gekennzeichnet,**
**dass** mit der Leiterplatte (24) signalverarbeitende Elektronikbauteile (27) mechanisch und elektrisch verbunden sind, die zumindest teitweise über die Leiterplatte (24) mit dem mindestens einen Steckverbinder (25, 26) an der Leiterplatte (24) verbunden sind.

12. Verbindungseinheit an einer Vakuumpumpe nach einem der vorangehenden Ansprüche,
**dadurch gekennzeichnet,**
**dass** mit der Leiterplatte (24) Speicherbauelemente (27) mechanisch und elektrisch verbunden sind, in denen Fertigungs-, Einstell- und/oder Betriebsdaten gespeichert sind.

## Claims

1. Electrical connection unit which is attached to a vacuum pump, having a vacuum-tight signal routing between an atmospheric side and a vacuum side of the connection unit, which sides are separated in a vacuum-tight manner by means of a single-layer through-plated ceramic plate (3),
wherein the ceramic plate (3) is clamped in a vacuum-tight manner between an atmospheric-side housing part (1) and a vacuum-side housing part (2) respectively between an elastic O-ring (4) on the atmospheric side of the ceramic plate (3) and an elastic sealing ring (6) on the vacuum side of the ceramic plate (3) by means of the atmospheric-side housing part (1) and the vacuum-side housing part (2),
wherein a circuit board (24) is arranged in the atmospheric-side housing part (1), which circuit board is connected in a signal-routing manner to through-connections (16, 16', 17, 17') of the ceramic plate (3) and wherein at least one connector (25, 26) is arranged on the circuit board (24), which connector is in signal-routing contact with the through-connections (16, 16', 17, 17') of the ceramic plate (3) via the circuit board (24) and can be connected outside of the atmospheric-side housing part (1).

2. Connection unit to a vacuum pump according to claim 1,
**characterised in that**,
on the vacuum side of the ceramic plate (3), at least one connector (18, 19) is mounted, which is connected in a signal-routing manner, via the through-connections (16, 16', 17, 17') of the ceramic plate (3), to the connector (25, 26) on the atmospheric-side housing part (1) which can be connected externally on the atmospheric side.

3. Connection unit to a vacuum pump according to either claim 1 or claim 2,
**characterised in that**
the atmospheric-side housing part (1) and the vacuum-side housing part (2) are screwed together while enclosing the ceramic plate (3), the elastic O-ring (4) and the elastic sealing ring (6).

4. Connection unit to a vacuum pump according to any of the preceding claims,
**characterised in that**
a groove (5) is formed in a section of the atmospheric-side housing part (1) facing the ceramic plate (3), in which groove the elastic O-ring (4) is arranged, **in that** a groove (7) is formed in an opposite section of the vacuum-side housing part (2) facing the ceramic plate (3), in which groove the elastic sealing ring (6) is arranged,
and **in that** a pump housing sealing groove (31) is formed in a section of the vacuum-side housing part (2) which opposes the ceramic plate (3), which groove is suitable for receiving an elastic pump housing sealing ring (32).

5. Connection unit to a vacuum pump according to claim 4,
**characterised in that**
the groove (5) formed from the atmospheric-side housing part (1), together with the groove (7) which is formed from the vacuum-side housing part (2), are arranged in alignment with each other.

6. Connection unit to a vacuum pump according to any of the preceding claims,
**characterised in that**
a collar-shaped section (28) is formed externally from the vacuum-side housing part (2), which section has pump housing screw connection holes (29, 30).

7. Connection unit to a vacuum pump according to any of the preceding claims,
**characterised in that**
the circuit board (24) is connected directly to the ceramic plate (3) on the atmospheric side thereof by means of a male connector (22) and a female connector (23).

8. Connection unit to a vacuum pump according to any of the preceding claims,
**characterised in that**
the ceramic plate (3) is completely coated at least on one side.

9. Connection unit to a vacuum pump according to claim 8.
**characterised by**
an insulating material as the coating.

10. Connection unit to a vacuum pump according to claim 8,
**characterised by**
a layer protecting against environmental influences as the coating.

11. Connection unit to a vacuum pump according to any of the preceding claims,
**characterised in that**
signal-processing electronic components (27) are mechanically and electrically connected to the circuit board (24), which components are connected at least partially via the circuit board (24) to the at least one connector (25, 26) on the circuit board (24).

12. Connection unit to a vacuum pump according to any of the preceding claims,
**characterised in that**
memory components (27) are connected mechanically and electrically to the circuit board (24) in which components manufacturing data, configuration data and/or operating data are stored.

## Revendications

1. Unité de connexion électrique raccordée à une pompe à vide avec un système de conduction de signaux, étanche au vide entre un côté sous une atmosphère et un côté sous vide de l'unité de connexion, qui sont séparés de manière étanche au vide au moyen d'une plaque de céramique (3) à une couche munie de vias,
la plaque de céramique (3) étant coincée de manière étanche au vide entre une partie de boîtier du côté sous atmosphère (1) et une partie de boîtier du côté sous vide (2) entre respectivement un joint torique (4) du côté sous atmosphère de la plaque de céramique (3) et une bague d'étanchéité élastique (6) sur son côté sous vide de la plaque de céramique (3) au moyen de la partie de boîtier du côté sous atmosphère (1) et de la partie de boîtier du côté sous vide (2),
un circuit imprimé (24) étant disposé dans la partie de boîtier du côté sous atmosphère (1), le circuit imprimé étant relié en conduisant des signaux avec des vias (16, 16', 17, 17') de la plaque de céramique (3) et
au moins un connecteur (25, 26) étant agencé sur le circuit imprimé (24), qui est en liaison par conduction de signaux avec les vias (16, 16', 17, 17') de la plaque de céramique (3) par l'intermédiaire du circuit imprimé (24) et qui peut être raccordé à l'extérieur de la partie de boîtier du côté sous atmosphère (1).

2. Unité de connexion raccordée à une pompe à vide selon la revendication 1,
**caractérisée en ce**
**que**, sur le côté sous vide de la plaque de céramique (3), au moins un connecteur (18, 19) est rapporté, qui est relié en conduisant des signaux avec un connecteur (25, 26) pouvant être raccordé à l'extérieur sur le côté sous atmosphère sur la partie de boîtier du côté sous atmosphère (1) par l'intermédiaire des vias (16, 16', 17, 17') de la plaque de céramique (3).

3. Unité de connexion à une pompe sous vide selon les revendications 1 ou 2,
**caractérisée en ce**
**que** la partie de boîtier du côté sous atmosphère (1) et la partie de connexion du côté sous vide (2) sont vissées ensemble en incluant la plaque de céramique (3), le joint torique (4) et la bague d'étanchéité élastique (6).

4. Unité de connexion à une pompe sous vide selon l'une des revendications précédentes,
**caractérisée en ce**
**que**, dans une portion de la partie de boîtier du côté sous atmosphère (1) orientée vers la plaque de céramique (3), une rainure (5) a été rajoutée, dans laquelle est agencé le joint torique (4),
**que**, dans une portion de la partie de boîtier du côté sous vide orientée vers la plaque de céramique (3), située à l'opposé, une rainure (7) a été rajoutée, dans laquelle est agencée la bague d'étanchéité élastique (6), et
**que**, dans une portion de la partie de boîtier du côté sous vide qui est orientée à l'opposé de la plaque de céramique (3), une rainure d'étanchéité de carter de pompe (31) a été rajoutée, qui est approprié pour l'admission d'un anneau d'étanchéité de carter de pompe élastique (32).

5. Unité de connexion à une pompe à vide selon la revendication 4
**caractérisée en ce**
**que** la rainure (5) conçue sur la partie de boîtier du côté sous atmosphère (1), ainsi que la rainure (7) conçue sur la partie de boîtier du côté sous vide (2) sont disposées alignées l'une par rapport à l'autre.

6. Unité de connexion à une pompe à vide selon l'une des revendications précédentes,
**caractérisée en ce**
**qu'**une portion en forme de collerette (28) est rajoutée à l'extérieur de la partie de boitier du côté sous vide (2) qui présente des alésages pour le vissage de carter de pompe (29, 30).

7. Unité de connexion à une pompe à vide selon l'une des revendications précédentes,
**caractérisée en ce**
**que** le circuit imprimé (24) est relié de manière immédiate avec la plaque de céramique (3) sur son côté sous atmosphère au moyen d'un connecteur mâle (22) et d'un connecteur femelle (23).

8. Unité de connexion à une pompe à vide selon l'une des revendications précédentes,
**caractérisée en ce**
**que** la plaque de céramique (3) est totalement pourvue d'un revêtement au moins sur un côté.

9. Unité de connexion à une pompe à vide selon la revendication 8,
**caractérisée par**
une matière isolante servant de revêtement.

10. Unité de connexion à une pompe à vide selon la revendication 8,
**caractérisée par**
une couche de protection contre les effets environnementaux servant de revêtement.

11. Unité de connexion à une pompe à vide selon l'une des revendications précédentes,
**caractérisée en ce**
**que** des composants électroniques (27) traitant des signaux, qui sont reliés avec l'au moins un connecteur (25, 26) sur le circuit imprimé (24), sont reliés mécaniquement et électriquement avec le circuit imprimé (24) au moins partiellement par l'intermédiaire du circuit imprimé (24).

12. Unité de connexion à une pompe à vide selon l'une des revendications précédentes,
**caractérisée en ce**
**que** des composants de mémoire (27), dans lesquels sont enregistrées des données de fabrication, de réglage et/ou de fonctionnement, sont reliés mécaniquement et électriquement avec le circuit imprimé (24).
